# EUROPÄISCHE PATENTSCHRIFT

(11) **EP 3 084 851 B1**
(45) Veröffentlichungstag und Bekanntmachung des Hinweises auf die Patenterteilung: **13.06.2018**
(21) Anmeldenummer: 14805865.4
(22) Anmeldetag: 28.11.2014
(51) Int. Cl.: H01L 35/32

(54) **THERMOELEKTRISCHE VORRICHTUNG UND VERFAHREN ZUM HERSTELLEN EINER THERMOELEKTRISCHEN VORRICHTUNG**
THERMOELECTRIC DEVICE AND METHOD FOR PRODUCING A THERMOELECTRIC DEVICE
DISPOSITIF THERMOÉLECTRIQUE ET PROCÉDÉ DE FABRICATION D'UN DISPOSITIF THERMOÉLECTRIQUE

(30) Priorität: 19.12.2013 DE 102013226598
(43) Veröffentlichungstag der Anmeldung: 26.10.2016
(73) Patentinhaber: Robert Bosch GmbH, 70442 Stuttgart (DE)
(72) Erfinder: ZOLLER, Tobias, 72622 Nuertingen (DE); EHRENPFORDT, Ricardo, 70825 Korntal-Muenchingen (DE); ANTE, Frederik, 70197 Stuttgart (DE); RANK, Holger, 71254 Ditzingen (DE)
(86) Internationale Anmeldenummer: PCT/EP2014/075887
(87) Internationale Veröffentlichungsnummer: WO 2015/090902

(56) Entgegenhaltungen:
- EP-A1- 2 234 151
- DE-A1-102011 075 661
- JP-A- 2003 142 739
- US-A1- 2013 192 655

## Beschreibung

### Stand der Technik

Die vorliegende Erfindung bezieht sich auf eine thermoelektrische Vorrichtung und auf ein Verfahren zum Herstellen einer thermoelektrischen Vorrichtung.

Das "Internet der Dinge" (Internet of Things, loT) wird als eine der wichtigsten zukünftigen Entwicklungen in der Informationstechnologie bezeichnet. Unter dem loT versteht man, dass nicht nur Menschen Zugang zum Internet haben und über dieses vernetzt sind, sondern dass auch Geräte über das Internet miteinander vernetzt sind. Ein Bereich des "Internet der Dinge" zielt in Richtung Produktions- und Hausautomatisierung, z. B. im Bereich der Temperaturmessung. Hierfür sind geeignete Sensoren bereits verfügbar, z. B. gibt es Temperatursensoren an der Heizung unter Einsatz der Low-Energy-Funktechnolgie. Jedoch liegen die Kosten mit ca. 100 Euro pro Sensor sehr hoch. Derzeit versuchen viele Unternehmen, die Erfahrungen aus dem Bereich Consumer Electronics, speziell in Bezug auf Sensoren für Smartphones (Gyros, Beschleunigungssensoren, Drucksensoren, Mikrofone), aufzugreifen und kostengünstige Sensoren für unter einen Euro herzustellen, die gleichzeitig die benötigte elektrische Energie mit sogenannten "Energy Harvestern" aus der Umwelt gewinnen. Klassische Harvester sind zur Energiegewinnung aus Sonnenlicht eingesetzte PV-Zellen und thermoelektrische Generatoren (TEGs), die für eine Energiegewinnung aus einer Temperaturdifferenz, z. B. an einer Heizung, eingesetzt werden können.

Die DE 10 2011 075 661 A1 offenbart eine thermoelektrische Anordnung.

Die EP2234151 A1 offenbart eine Halbleitervorrichtung mit Bildgebungsfunktion, deren Wärmeabstrahleigenschaften verbessert werden sollen, um eine Verschlechterung der Bildqualität in Folge eines Temperaturanstiegs zu verhindern. Hierzu wird eine Kühlung unter Verwendung eines Peltier-Elements und/ oder eines Ventilators für die Halbleitervorrichtung bereitgestellt.

Die US 2013/0192655 A1 offenbart ein in einer Leiterplatte eingebettetes thermoelektrisches Element. Dies hat zum Ziel das thermoelektrisches Element in die Leiterplatte einzubetten, ohne dass das thermoelektrische Element bei der Integration in die Leiterplatte aufgrund des Leiterplatten-Herstellungsprozesses beschädigt wird. Des Weiteren werden gute elektrische und thermische Kontakte zu dem thermoelektrischen Element, welches in die Leiterplatte eingebettet ist, durch eine feste thermische Verbindung zu einer Hitzequelle bzw. -senke realisiert.

### Offenbarung der Erfindung

Vor diesem Hintergrund wird mit der vorliegenden Erfindung eine thermoelektrische Vorrichtung sowie ein Verfahren zum Herstellen einer thermoelektrischen Vorrichtung gemäß den Hauptansprüchen vorgestellt. Vorteilhafte Ausgestaltungen ergeben sich aus den jeweiligen Unteransprüchen und der nachfolgenden Beschreibung.

Die unter Verwendung eines thermoelektrischen Generators gewonnene Energie steht in direktem Zusammenhang mit dem am thermoelektrischen Generator anliegenden Temperaturgradienten. Um den Temperaturgradienten an den thermoelektrischen Generator zu führen, kann mithilfe der Aufbau- und Verbindungstechnik ein Wärmepfad innerhalb eines Gehäuses oder Trägers des thermoelektrischen Generators hergestellt werden. Dieser Wärmepfad sollte im Idealfall einen niedrigen thermischen Widerstand aufweisen.

Mit einer Einbettung eines thermoelektrischen Elements bzw. Generators in eine mit einem elastischen Material ausgekleidete Vertiefung eines Trägers kann ein thermoelektrischer Generator unter Einsatz von Standard-Verpackungsprozessen mechanisch weitgehend entkoppelt und thermisch weitgehend verlustarm in eine Aufbau- und Verbindungstechnik eines autonomen Sensorsystems integriert werden.

Auch unter Verwendung des elastischen Materials anstelle mechanisch fester Materialien und Verbindungen kann ein optimaler Wärmepfad hergestellt werden. Gleichzeitig können über die so erreichbare weitgehende mechanische Entkopplung des thermoelektrischen Bauelements Beeinträchtigungen desselben aufgrund von Stößen oder temperaturbedingten Spannungen innerhalb der thermoelektrischen Vorrichtungen vorteilhaft vermieden werden.

Gemäß dem hier vorgestellten Konzept kann die Problematik des mechanischen Stresses durch z. B. unterschiedliche thermische Ausdehnungskoeffizienten verwendeter Verbindungsmaterialien oder des chemischen Schrumpfs direkt an den thermoelektrischen Generatoren vermieden oder zumindest verringert werden.

Ferner kann durch die Vertiefung im Träger das elastische Material zur Entkopplung sehr einfach beispielsweise durch Dispensen, Drucken oder Jetten eingebracht und in seiner Ausdehnung und Füllhöhe eingestellt werden. Durch den umlaufenden Kontakt des elastischen Materials zum thermoelektrischen Bauelement auch im Bereich der Stirnflächen kann das thermoelektrische Bauelement wirksam mechanisch gegen Kippbewegungen stabilisiert und gedämpft werden. Insbesondere kann in einer Weiterführung des hierin vorgeschlagenen Ansatzes mit einer Füllhöhe des elastischen Materials über den die thermoelektrischen Elemente aufweisenden Zwischenbereich hinaus diese für Beschädigungen anfällige Bondstelle zwischen der Heiß- und Kaltseite des thermoelektrischen Bauelements stabilisiert werden. So kann die Gefahr eines Funktionsausfalls des kompletten thermoelektrischen Bauelements, der aufgrund der vorliegenden Reihenschaltung bereits beim Versagen lediglich eines der Mehrzahl thermoelektrischer Elemente eintreten würde, ausgeschaltet oder zumindest beträchtlich verringert werden.

Eine thermoelektrische Vorrichtung weist die folgenden Merkmale auf:
einen Träger, wobei eine Oberfläche des Trägers eine Vertiefung aufweist;
ein elastisches Material, mit dem zumindest ein Boden der Vertiefung ausgekleidet ist; und
ein thermoelektrisches Bauelement, das in der Vertiefung angeordnet ist, wobei das thermoelektrische Bauelement über das elastische Material mit dem Träger verbunden ist, und wobei das thermoelektrische Bauelement eine dem Boden der Vertiefung zugewandte erste Platte, eine von dem Boden der Vertiefung abgewandte zweite Platte und einen Zwischenbereich mit einer Mehrzahl von sich zwischen der ersten Platte und der zweiten Platte erstreckenden thermoelektrischen Elementen aufweist.

Die thermoelektrische Vorrichtung kann beispielsweise zur Erzeugung einer elektrischen Spannung unter Ausnutzung einer Temperaturdifferenz eingesetzt werden. Ein möglicher Einsatzort der thermoelektrischen Vorrichtung ist somit beispielsweise ein Heizkörper. Bei dem Träger kann es sich um eine Platte handeln, deren Dicke ausreichend für eine Ausbildung der Vertiefung ist. Beispielsweise kann es sich bei dem Träger um eine Leiterplatte handeln. Die Vertiefung kann wannenförmig sein und größere Abmessungen als das thermoelektrische Bauelement aufweisen. Bei dem elastischen Material kann es sich um ein Kunststoffmaterial handeln, das in Form einer durchgängigen Schicht auf dem Boden und/oder der Wandung der Vertiefung anliegt. Die Vertiefung kann insbesondere so mit dem elastischen Material und/oder einem weiteren elastischen Material ausgekleidet sein, dass Boden und Wandung der Vertiefung vollständig mit dem elastischen Material und/oder dem weiteren elastischen Material bedeckt sind. Bei dem thermoelektrischen Bauelement handelt es sich um einen thermoelektrischen Generator zum Erzeugen elektrischer Energie aus einer Temperaturdifferenz zwischen der ersten und der zweiten Platte. Das thermoelektrische Bauelement kann in Form eines Peltier-Elements aufgebaut sein, wobei die erste Platte eine Warmseite und die zweite Platte eine Kaltseite des Peltier-Elements bilden kann. Die Platten können beispielsweise aus Keramik sein und Metallbrücken zum Verbinden benachbarter thermoelektrischer Elemente aufweisen. Die den Zwischenbereich bildenden thermoelektrischen Elemente können ein Halbleitermaterial aufweisen. Die thermoelektrischen Elemente können in Form von die erste von der zweiten Platte beabstandenden sogenannten "Beinchen" ausgebildet und an ihren jeweiligen beiden Enden fest mit der ersten und der zweiten Platte verbunden sein. Das elastische Material kann so zwischen dem thermoelektrischen Bauelement und der Vertiefung angeordnet sein, dass ein Zwischenraum zwischen dem thermoelektrischen Bauelement und der Vertiefung vollständig ausgefüllt ist.

Gemäß einem Ausführungsbeispiel der thermoelektrischen Vorrichtung kann der Zwischenbereich des thermoelektrischen Bauelements innerhalb der Vertiefung angeordnet sein. Dazu kann das thermoelektrische Bauelement so in der Vertiefung angeordnet sein, dass eine Oberkante einer Wandung der Vertiefung den Zwischenbereich überragt. Die Oberkante kann an einem Übergang von der Oberfläche des Trägers zu der Wandung der Vertiefung einen umlaufenden Abschluss der Vertiefung bilden. Mit dieser Ausführungsform kann der bruchempfindliche Zwischenbereich des thermoelektrischen Bauelements vorteilhaft vor Beschädigungen geschützt werden, insbesondere, wenn sich das elastische Material bis zu der Oberkante der Wandung hin erstreckt.

Der Boden der Vertiefung kann beispielsweise als ein metallischer Einsatz in den Träger ausgebildet sein. Hierzu kann der Träger eine Öffnung oder Durchgangsöffnung aufweisen, in die im Herstellungsprozess der thermoelektrischen Vorrichtung der metallische Einsatz zur Bildung des Bodens bzw. mindestens eines Teilbereiches des Bodens eingesetzt werden kann. Alternativ kann der metallische Einsatz im Herstellungsprozess des Trägers eingeklebt, eingelötet oder eingepresst werden. Es kann sich bei dem für den Einsatz verwendeten Metall um ein Metall mit besonders guter Wärmeleitfähigkeit wie z. B. Kupfer handeln. Diese Ausführungsform weist den Vorteil auf, dass ein Wirkungsgrad der durch die erste Platte gebildeten Warmseite des thermoelektrischen Bauelements auf einfache Weise erhöht werden kann.

Alternativ kann der Boden der Vertiefung einstückig mit dem Träger gebildet sein und zumindest eine metallische Durchkontaktierung aufweisen. Diese Ausführungsform erhöht vorteilhaft eine Stabilität des Trägers und damit der gesamten thermoelektrischen Vorrichtung. Auch mit dieser Ausführungsform kann durch die durch die Verwendung des Metalls verbesserte Wärmeleitung der Wirkungsgrad des thermoelektrischen Bauelements vorteilhaft erhöht werden.

Gemäß einer weiteren Ausführungsform der thermoelektrischen Vorrichtung kann das elastische Material ein thermisch isolierendes Material sein. Damit können den Wirkungsgrad der thermoelektrischen Vorrichtung beeinträchtigende Wärmeverluste der Warmseite des thermoelektrischen Bauelements auf einfache Weise vermieden werden.

Alternativ kann das elastische Material ein thermisch leitendes Material sein. In dieser Ausführung der thermoelektrischen Vorrichtung kann der Wärmegradient besonders effizient von außen an die Warmseite des thermoelektrischen Bauelements herangeführt werden.

Beispielsweise kann das elastische Material in einem Bereich zwischen dem Boden der Vertiefung und der ersten Platte des thermoelektrischen Bauelements einen Füllstoff zur Erhöhung einer thermischen Leitfähigkeit zwischen dem Träger und der ersten Platte des thermoelektrischen Bauelements aufweisen. Bei dem Füllstoff kann es sich um in dem Bereich zwischen dem Boden der Vertiefung und der ersten Platte beabstandet eingebrachte, den Boden mit der Platte verbindende Strukturen - z. B. metallische Spacer (Kugeln) - handeln, die mittels eines für sie verwendeten Materials - z. B. Metall - oder einer sonstigen Ausprägung geeignet sind, eine Mehrzahl von Wärmekorridoren zwischen dem Träger und der Warmseite des thermoelektrischen Bauelements bereitzustellen. So kann der Wärmegradient besonders kontrolliert und gerichtet an die Warmseite geleitet werden. Verluste durch Streuwärme können minimiert oder ganz ausgeschaltet werden.

Gemäß einer Ausführungsform kann die thermoelektrische Vorrichtung ein weiteres elastisches Material aufweisen, das zwischen der Wandung der Vertiefung und dem thermoelektrischen Bauelement angeordnet ist. Das weitere elastische Material kann thermisch isolierend sein. So kann auf einfache und effektive Weise verhindert werden, dass zu Seitenbereichen des thermoelektrischen Bauelements hin ein Wärmeverlust stattfindet bzw. Heiß- und Kaltseite des thermoelektrischen Bauelements thermisch kurzgeschlossen werden.

Ferner kann die thermoelektrische Vorrichtung einen Deckel zur zumindest teilweisen Abdeckung des thermoelektrischen Bauelements aufweisen. Dabei kann ein Randbereich des Deckels mittels eines Haftmittels an der Oberfläche des Trägers befestigt sein. So kann der aus der Vertiefung herausragende Abschnitt des thermoelektrischen Bauelements effektiv vor Beschädigungen geschützt werden. Das Haftmittel kann thermisch isolierend sein. Über das Haftmittel kann eine elastische Verbindung des Deckels mit dem Träger realisiert und damit eine mechanische Entkopplung des an den Deckel anliegenden thermoelektrischen Bauelements von dem Träger erreicht werden. Zur noch weiter verbesserten mechanischen Entkopplung kann eine Schicht elastischen Materials in einem Zwischenraum zwischen einer Hauptfläche der zweiten Platte des thermoelektrischen Bauelements und einer Innenseite des Deckels angeordnet sein.

Der Deckel kann zudem ausgebildet sein, um zumindest ein weiteres Modul der thermoelektrischen Vorrichtung abzudecken. So können auf einfache Weise empfindliche Bauteile der thermoelektrischen Vorrichtung und eventuelle Verbindungsleitungen zwischen dem weiteren Modul und dem thermoelektrischen Bauelement mit einem einzigen Element vor Beschädigungen geschützt werden.

Ein Verfahren zum Herstellen einer thermoelektrischen Vorrichtung weist die folgenden Schritte auf:
Bereitstellen eines thermoelektrischen Bauelements, das eine erste Platte, eine zweite Platte und einen Zwischenbereich mit einer Mehrzahl von sich zwischen der ersten Platte und der zweiten Platte erstreckenden thermoelektrischen Elementen aufweist;

Bereitstellen eines Trägers, wobei eine Oberfläche des Trägers eine Vertiefung aufweist;

Einbringen eines elastischen Materials in die Vertiefung des Trägers, um den Freiraum zumindest teilweise zu füllen; und

Einsetzen des thermoelektrischen Bauelements in die Vertiefung, um das thermoelektrische Bauelement über das elastische Material mit dem Träger zu verbinden.

Das Verfahren kann von Einrichtungen einer prozessgesteuerten Fertigungsstrecke ausgeführt werden, sodass eine Vielzahl von thermoelektrischen Vorrichtungen in kurzer Zeit produziert werden kann. Die Vertiefung in dem Träger kann in einem früheren Schritt des hier erläuterten Herstellungsverfahrens oder in einem anderen Herstellungsverfahren gefertigt worden sein, beispielsweise in einem Ätzprozess. In dem Schritt des Einbringens kann das elastische Material beispielsweise durch Dispensen, Drucken oder Jetten eingebracht werden. Anschließend kann das thermoelektrische Bauelement in einer definierten Höhe, die z. B. durch metallische Spacer in dem elastischen Material oder die Verwendung eines formstabilen elastischen Materials bzw. Nonflow-Materials vorgegeben ist, in die Vertiefung eingesetzt werden.

Die Erfindung wird nachstehend anhand der beigefügten Zeichnungen beispielhaft näher erläutert. Es zeigen:
- Fig. 1: eine Schnittdarstellung einer thermoelektrischen Vorrichtung gemäß einem Ausführungsbeispiel der vorliegenden Erfindung;
- Fig. 2: eine Schnittdarstellung einer thermoelektrischen Vorrichtung gemäß einem weiteren Ausführungsbeispiel der vorliegenden Erfindung;
- Fig. 3: einen Detailausschnitt aus der thermoelektrischen Vorrichtung aus Fig. 2, gemäß einem Ausführungsbeispiel der vorliegenden Erfindung;
- Fig. 4: einen Detailausschnitt aus der thermoelektrischen Vorrichtung aus Fig. 2, gemäß einem weiteren Ausführungsbeispiel der vorliegenden Erfindung;
- Fig. 5: einen Detailausschnitt aus der thermoelektrischen Vorrichtung aus Fig. 2, gemäß einem weiteren Ausführungsbeispiel der vorliegenden Erfindung;
- Fig. 6: eine Schnittdarstellung einer thermoelektrischen Vorrichtung mit weiteren Modulen, gemäß einem Ausführungsbeispiel der vorliegenden Erfindung;
- Fig. 7: eine Schnittdarstellung einer thermoelektrischen Vorrichtung mit weiteren Modulen, gemäß einem weiteren Ausführungsbeispiel der vorliegenden Erfindung;
- Fig. 8: eine Schnittdarstellung einer thermoelektrischen Vorrichtung mit weiterem Modul und Deckel mit Rippenstruktur, gemäß einem Ausführungsbeispiel der vorliegenden Erfindung; und
- Fig. 9: ein Ablaufdiagramm eines Verfahrens zum Herstellen einer thermoelektrischen Vorrichtung, gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

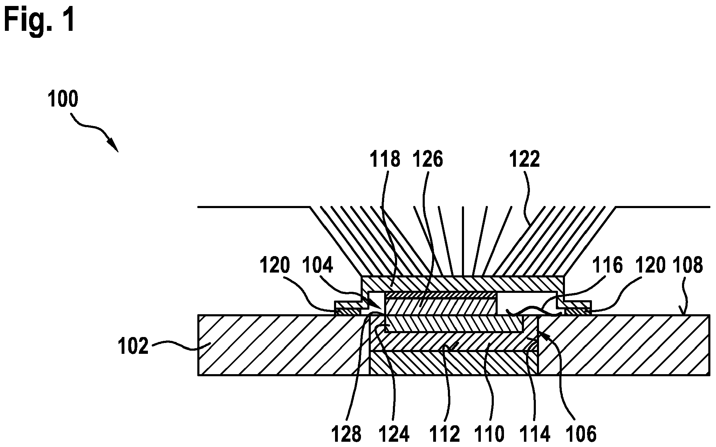

Fig. 1 zeigt anhand einer Schnittdarstellung eine thermoelektrische Vorrichtung 100 gemäß einem Ausführungsbeispiel der vorliegenden Erfindung. Die thermoelektrische Vorrichtung 100 umfasst einen Träger 102 und ein thermoelektrisches Bauelement 104. Das thermoelektrische Bauelement 104 ist in einer Vertiefung 106 angeordnet, die aus einer Oberfläche 108 des Trägers 102 herausgearbeitet ist. Die Vertiefung 106 ist mit einem elastischen Material 110 ausgekleidet, über das das thermoelektrische Bauelement 104 mit dem Träger bzw. Trägersubstrat 102 stressentkoppelt verbunden ist. Wie die Darstellung in Fig. 1 deutlich zeigt, bedeckt bei dem hier gezeigten Ausführungsbeispiel der thermoelektrischen Vorrichtung 100 das elastische Material 110 einen Boden 112 und eine Wandung 114 der Vertiefung 106 vollständig. Gemäß alternativen Ausführungsbeispielen kann beispielsweise nur der Boden 112 oder der Boden 112 und die Wandung 114 lediglich bis zu einer gewissen Höhe das elastische Material 110 aufweisen. Eine elektrische Anbindung des thermoelektrischen Bauelements 104 an den Träger ist über Drahtverbindungen bzw. Drahtbonds 116 realisiert. Ferner weist die thermoelektrische Vorrichtung 100 einen Deckel 118 auf, der das thermoelektrische Bauelement 104 überspannt und zumindest teilweise abdeckt. Der Deckel ist in einem Randbereich mittels eines Haftmaterials 120 an der Oberfläche 108 des Trägers 102 befestigt. Auch zwischen dem thermoelektrischen Bauelement 104 und einer Innenseite des Deckels 118 ist eine Schicht des Haftmaterials 120 angeordnet. Auf dem Deckel 118 befindet sich ein Kühlkörper 122 zum Kühlen des thermoelektrischen Bauelements 104.

Bei dem Träger 102 handelt es sich hier um eine Leiterplatte, die zusätzlich zu dem thermoelektrischen Bauelement 104 mit noch weiteren elektronischen Bauelementen bzw. Bauteilen bestückt sein kann. Das thermoelektrische Bauelement 104 ist bei dem in Fig. 1 gezeigten Ausführungsbeispiel der thermoelektrischen Vorrichtung 100 als ein thermoelektrischer Generator bzw. TEG ausgeführt und setzt sich aus einer Unterseite bzw. ersten Platte 124, einer Oberseite bzw. zweiten Platte 126 und einem zwischen der ersten Platte 124 und der zweiten Platte 126 angeordneten - in der Darstellung in Fig. 1 nicht explizit dargestellten - Zwischenbereich 128 zusammen. Der Zwischenbereich 128 wird durch eine Mehrzahl thermoelektrischer Elemente gebildet, auf die anhand der nachfolgenden Figuren noch detaillierter eingegangen wird. Die erste Platte 124 bildet hier die dem Boden 112 der Vertiefung 106 zugewandte Warmseite des thermoelektrischen Generators 104 und die zweite Platte 126 die dem Deckel 118 zugewandte Kaltseite des thermoelektrischen Generators 104. Bei dem in Fig. 1 gezeigten Ausführungsbeispiel ist das thermoelektrische Bauelement 104 so weit in die Vertiefung 106 eingebettet, dass eine Füllhöhe des elastischen Materials 110 den Zwischenbereich 128 erreicht.

Zur besseren Wärmeleitung ist der Boden 112 der Vertiefung 106 als ein metallischer Einsatz in den Träger 102 ausgebildet. Bei dem hier verwendeten Metall handelt es sich um Kupfer. Gemäß weiteren Ausführungsbeispielen kann auch ein anderes Metall mit guten Wärmeleitungseigenschaften verwendet werden. Alternativ zu der in Fig. 1 gezeigten Ausführung kann der Boden 112 einstückig mit dem Träger 102 gebildet sein und zumindest eine oder mehrere metallische Durchkontaktierungen aufweisen, um so die Wärmeleitung an den thermoelektrischen Generator 104 zu unterstützen.

Die in Fig. 1 gezeigte thermoelektrische Vorrichtung 100 kann als ein Sensormodul bzw. Sensorsystem eingesetzt werden, das im Kern wie bereits erläutert mindestens den Träger bzw. das Trägersubstrat 102, weiterhin mindestens einen thermoelektrischen Generator 104 und zudem das elastische Material 110 umfasst. Insbesondere ist dabei der thermoelektrische Generator 104 innerhalb des Trägers 102 in der Art eingebracht, dass die Vertiefung 106 den thermoelektrischen Generator 104 zumindest teilweise umgibt und der Bereich zwischen dem thermoelektrischen Generator 104 und den Wandungen 114 der Vertiefung 106 zumindest teilweise in der Art durch das elastische Material 110 ausgefüllt ist, dass kein mechanischer Kontakt zwischen thermoelektrischem Generator 104 und Träger 102 besteht; d. h., der thermoelektrische Generator 104 berührt den Träger 102 nicht direkt.

Gemäß einem Ausführungsbeispiel des Sensormoduls 100 mit stressentkoppelnder Substrat-AVT (AVT = Aufbau- und Verbindungstechnik) für den thermoelektrischen Generator 104 ist der den thermoelektrischen Generator 104 umgebende Teil der Vertiefung 106 zumindest bezüglich der horizontalen Grundfläche 112 und eines Teils der Stirnflächen des thermoelektrischen Generators 104 umgebenden vertikalen Wandungsflächen 114 mit dem elastischen Material 110 ausgekleidet.

Gemäß einem weiteren Ausführungsbeispiel ist das elastische Material 110 in der Vertiefung 106 ein thermisch isolierendes Material, und die vertikalen Wandungsflächen 114 des thermoelektrischen Generators 104 sind zumindest soweit mit dem isolierenden Material 110 bedeckt, dass der Zwischenbereich 128 der Beinchenpaare zwischen Kaltseite 126 und Heißseite 124 überragt und somit mechanisch stabilisiert wird, und im Bereich zwischen der Bodenfläche 112 der Vertiefung 106 und einer unteren horizontalen Grundfläche des thermoelektrischen Generators 104 sind Füllstoffe zur Erhöhung der thermischen Leitfähigkeit in das elastische Material 110 eingelassen.

Alternativ ist das Material 110 zwischen thermoelektrischen Generator 104 und Bodenflächenvertiefung 112 ein elastisches, thermisch leitendes Material, und ein weiteres Material an den Stirnflächen des thermoelektrischen Generators 104, das den "Beinchen-Paar-Bereich" 128 überragt, ist ein zweites thermisch isolierendes Material.

Zusätzlich können im "Bodenbereich" 112 der Vertiefung 106 Strukturen zur Erhöhung des Wärmetransportes eingelassen sein. Es kann sich bei den Strukturen im Bodenbereich 112 der Vertiefung 106 um mindestens einen metallischen Einsatz oder einen metallischen Durchkontakt handeln.

Gemäß Ausführungsbeispielen erhöht das elastische Material 110 den Wärmetransport gegenüber dem Trägermaterial 102 und/oder das elastische Material 110 enthält Strukturen oder Füllstoffe, die den Wärmetransport erhöhen.

Gemäß einem besonderen Ausführungsbeispiel der thermoelektrischen Vorrichtung 100 wird der thermoelektrische Generator 104 von der Abdeckung bzw. dem Deckel 118 in der Art überragt, dass die Abdeckung 118 auf der oberen Abschlusskante der Vertiefung 106, ausgeprägt durch die Oberfläche 108 des Trägers 102, den thermoelektrischen Generator 104 umlaufend aufsitzt und die vertikalen Wandungsflächen bzw. Stirnflächen des thermoelektrischen Generators 104 nur zu einem Teil abgedeckt werden.

Wie bereits erläutert, ist der Deckel 118 durch ein Haftmaterial 120 wie z. B. Kleber oder Lot auf dem Träger 102 befestigt. Auch bei dem Haftmaterial 120 kann es sich beispielsweise um ein thermisch isolierendes Material handeln.

Die Abdeckung 118 kann gemäß Ausführungsbeispielen weitere elektronische Bauelemente überdecken und/oder rippenähnliche Strukturen aufweisen. Dabei können die weiteren Bauelemente auf dem Träger 102 in eine Gussmasse bzw. Vergussmasse bzw. Pressmasse eingelassen sein. Auch die Abdeckung 118 kann zumindest teilweise in die Vergussmasse eingelassen sein. Beispielsweise kann der Deckel 118 im Bereich der mechanischen Befestigung am Träger 102 zumindest teilweise in die Vergussmasse eingelassen sein.

Gemäß einem weiteren Ausführungsbeispiel wird zwischen der Abdeckung 118 und dem thermoelektrischen Generator 104 ein mechanischer Verbund durch das elastische Material 110 oder ein weiteres elastisches Material hergestellt. Insbesondere kann das elastische Material 110 den Wärmetransport gegenüber dem Trägermaterial 102 erhöhen. An sämtlichen Positionen innerhalb der thermoelektrischen Vorrichtung 100 kann das elastische Material 110 Strukturen oder Füllstoffe enthalten, die den Wärmetransport erhöhen.

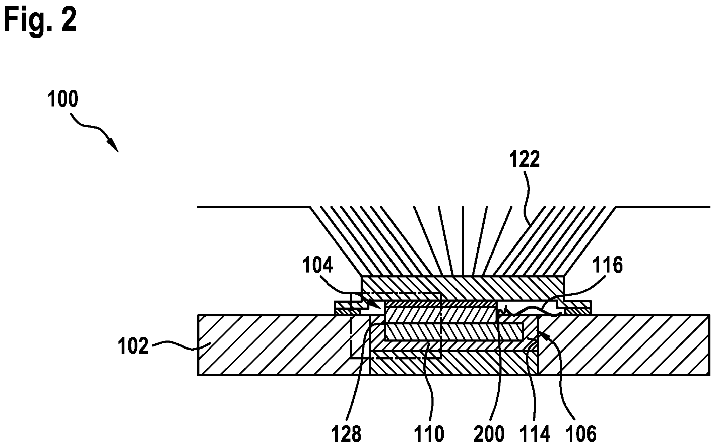

Fig. 2 zeigt eine Schnittdarstellung eines weiteren Ausführungsbeispiels der thermoelektrischen Vorrichtung 100. Auch hier ist die thermoelektrische Vorrichtung 100 als ein Sensorknoten mit thermoelektrischem Generator 104 ausgeführt. Der Träger 102 in Form einer Leiterplatte mit mindestens einer Verdrahtungsebene kann zusätzlich mit elektronischen Bauteilen und Sensoren bestückt sein. Wiederum ist in der Leiterplatte 102 die Vertiefung 106 eingebracht, in der das elastische Material 110 zur mechanischen Dämpfung verfüllt ist. Der thermoelektrische Generator 104 ist in der Vertiefung 106 eingelassen und durch Drahtbonds 116 kontaktiert. Der Kühlkörper 122 ist ebenfalls auf dem Träger 102 aufgebracht und mit einer Oberseite des thermoelektrischen Generators 104 verbunden. Im Unterschied zu dem in Fig. 1 gezeigten Ausführungsbeispiel ist hier das thermoelektrische Bauelement 104 so in der Vertiefung 106 angeordnet, dass eine Oberkante 200 der Wandung 114 den Zwischenbereich 128 überragt. Da die Wandung 114 bis zu ihrer Oberkante 200 mit dem elastischen Material 110 abgedeckt ist, ist damit insbesondere der Zwischenbereich 128 mit den empfindlichen thermoelektrischen Elementen gut geschützt und gepuffert.

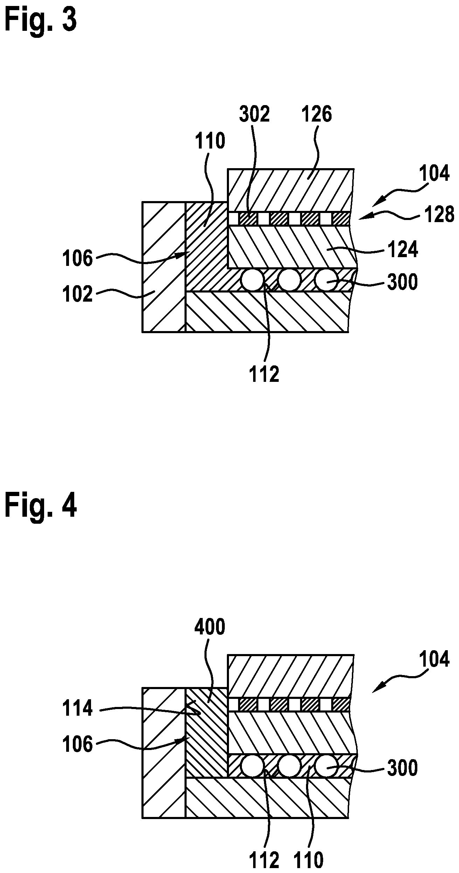

Fig. 3 zeigt einen mittels eines rechteckigen Rahmens in Fig. 2 gekennzeichneten Detailausschnitt aus der thermoelektrischen Vorrichtung aus Fig. 2, gemäß einem Ausführungsbeispiel der vorliegenden Erfindung. In der Detaildarstellung in Fig. 3 ist die Vertiefung 106 in dem Träger 102 mit bestücktem, von dem thermisch isolierenden elastischen Material 110 umgebenen, thermoelektrischen Generator 104 dargestellt. Wie die Darstellung in Fig. 3 deutlich zeigt, ist bei dem hier gezeigten Ausführungsbeispiel im Bodenbereich 112 unterhalb des thermoelektrischen Generators 104 eine Struktur in Form von Füllstoffen 300 angeordnet und der Bodenbereich 112 als metallisches Insert in die Leiterplatte 102 integriert, um die thermische Leitfähigkeit der thermoelektrischen Vorrichtung zu erhöhen. Bei den Füllstoffen bzw. der Struktur 300 handelt es sich hier um Kupferspacer. Auch andere gut Wärme leitende Metalle sind denkbar. Die Füllstoffe können im Bereich zwischen dem thermoelektrischen Generator 104 und Boden 112 der Vertiefung 106 an einer geeigneten Stelle oder beabstandet über diesen Bereich verteilt eingebracht sein. Bei dem in Fig. 3 gezeigten Ausführungsbeispiel ist zur thermischen Optimierung des Aufbaus der erfindungsgemäßen thermoelektrischen Vorrichtung eine Mehrzahl der optional zu verwenden Füllstoffe 300 so angeordnet, dass sie sowohl den Boden der Vertiefung 106 als auch eine Unterseite der ersten Platte 124 des thermoelektrischen Generators 104 berühren.

Zudem zeigt die Detaildarstellung in Fig. 3 deutlich den Zwischenbereich 128, der eine Mehrzahl von sich zwischen der ersten Platte 124 und der zweiten Platte 126 des thermoelektrischen Generators 104 erstreckenden thermoelektrischen Elementen 302 aufweist. Bei aktuellen miniaturisierten thermoelektrischen Generatoren 104 sind die Heißseite 124 und die Kaltseite 126 mit einer hohen Anzahl dieser thermoelektrischen Elemente 302, die auch als thermoelektrische "Bein-Paare" bezeichnet werden können, miteinander verbunden. Eine beispielhafte Ausführung verwendet 540 "Bein-Paare" 302. Diese thermoelektrischen "Bein-Paare" 302 sind thermisch parallel, jedoch elektrisch in Reihe geschaltet, um eine möglichst hohe Ausgangsspannung pro Kelvin zu erreichen. Die "Beine" 302 bestehen aus thermoelektrischem Material, z. B. Bi₂Te₃, und sind meist durch eine sehr kleine Grundfläche, z. B. 30 µm x 30 µm, und eine niedrige mechanische Stabilität gekennzeichnet. Mit der bei dem in Fig. 3 gezeigten Ausführungsbeispiel realisierten Einbettung des thermoelektrischen Bauelements 104 in das elastische Material 110 über den Zwischenbereich 128 hinaus wird auf einfache Weise erreicht, dass das elastische Material 110 den thermoelektrischen Generator 104 und insbesondere den empfindlichen Zwischenbereich 128 stabilisiert.

Fig. 4 zeigt einen Detailausschnitt aus der thermoelektrischen Vorrichtung aus Fig. 2, gemäß einem weiteren Ausführungsbeispiel der vorliegenden Erfindung. Der Aufbau bei diesem Ausführungsbeispiel entspricht weitgehend dem des in Fig. 3 gezeigten Ausführungsbeispiels, mit dem Unterschied, dass hierein weiteres elastisches Material 400 zum Einsatz kommt, das zwischen der Wandung 114 der Vertiefung 106 und dem thermoelektrischen Bauelement 104 angeordnet ist.

Bei der erweiterten Detailbetrachtung des Sensorknotens mit dem thermoelektrischen Generator 104 in Fig. 4. Ist die Vertiefung 106 somit zwei elastischen Materialien 110, 400 mit unterschiedlichen Eigenschaften gefüllt. Bei dem in Fig. 4 gezeigten Ausführungsbeispiel ist das elastische Material 110 an der Unterseite des thermoelektrischen Generators 104 bzw. im Bodenbereich 112 der Vertiefung 106 angeordnet und zeigt eine gute thermische Leitfähigkeit, hier zudem gesteigert durch die Verwendung der Füllstoffe 300. Das zweite bzw. weitere elastische Material 400 bedeckt die Wandung 114 der Vertiefung 106 über ihre gesamte Höhe. Das zweite bzw. weitere elastische Material 400 besitzt im Vergleich zu dem elastischen Material 110 eine schlechtere thermische Leitfähigkeit bzw. ist thermisch isolierend und umschließt den thermoelektrischen Generator 104 an der Seite.

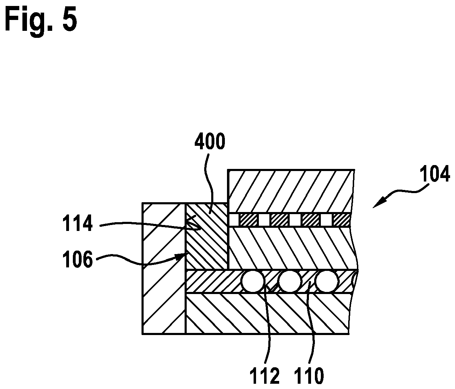

Fig. 5 zeigt anhand eines weiteren Detailausschnitts aus der thermoelektrischen Vorrichtung aus Fig. 2 eine von der Ausführung in Fig. 4 geringfügig abweichende Variante. Hier erstreckt sich das den Boden 112 der Vertiefung 106 bedeckende elastische Material 110 über die Unterseite des thermoelektrischen Bauelements 104 hinaus bis zu der Wandung 114. Dementsprechend bedeckt das weitere elastische Material 400 nur einen verbleibenden Restbereich der Wandung 114.

Damit verfügt das in Fig. 5 ausschnittsweise dargestellte Ausführungsbeispiel der erfindungsgemäßen thermoelektrischen Vorrichtung gegenüber dem anhand der Darstellung in Fig. 4 vorgestellten über eine höhere Wärmeleitungsleistung. Je nach Prozessfluss und Material kann in der praktischen Anwendung die anhand der Fig. 4 oder die anhand der Fig. 5 erläuterte Variante zielführend sein.

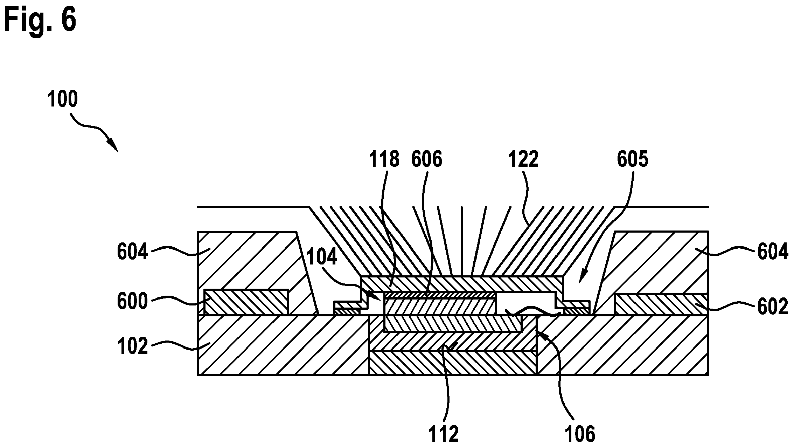

Fig. 6 zeigt anhand einer Schnittdarstellung ein weiteres Ausführungsbeispiel der thermoelektrischen Vorrichtung 100. Wiederum ist die thermoelektrische Vorrichtung 100 als ein Sensorknoten mit dem thermoelektrischen Generator 104 dargestellt. Bei dem hier gezeigten Ausführungsbeispiel ist der Träger bzw. die Leiterplatte 102 zusätzlich mit weiteren elektronischen Bauelementen wie einem elektronischen Bauteil 600 und einem Sensor 602 bestückt. Die Bestückung kann alternativ auch mehr oder weniger weitere Bauelemente umfassen. Die Darstellung in Fig. 6 zeigt, dass die weiteren Module 600, 602 von einer auf der Leiterplatte 102 angeordneten Moldmasse 604 bedeckt sind, während die thermoelektrische Vorrichtung 100 in einer Aussparung 605 aus der Moldmasse 604 angeordnet ist.

Dieser Aufbau wir erreicht, indem mithilfe eines speziellen Moldwerkzeuges beim Molden eine definierte Fläche von der Moldmasse frei gehalten wird. In diesem frei gehaltenen Bereich 605 befindet sich die thermische Anbindung für den thermoelektrischen Generator 104 mithilfe des in der Darstellung gezeigten Cu-Inserts als Boden 112 der Vertiefung 106 oder alternativ mittels thermischer Vias in der Leiterplatte 102. Um diese thermische Performance zu verbessern, können als eine Variation dieses Aufbaus zusätzlich Füllstoffe in Form von Kupferspacern unterhalb des thermoelektrischen Generators 104 eingebracht werden, analog zu den anhand der Figuren 3 bis 5 erläuterten Ausführungsbeispielen der thermoelektrischen Vorrichtung 100. Durch diese Füllstoffe wird die out-of-plane-Dämpfung zwar verschlechtert, jedoch die inplane-Dämpfung nahezu konstant gehalten. Der Kühlkörper 122 wird in die frei gehaltene Fläche auf die Leiterplatte verbunden und stellt eine Verbindung zum thermoelektrischen Generator 104 her. Der Kühlkörper 122 ist gleichzeitig mechanisch mithilfe eines zwischen dem Deckel 118 und dem thermoelektrischen Generator 104 angeordneten weichen Klebstoffes 606 entkoppelt, um die Zuverlässigkeit des thermoelektrischen Generators 104 zu gewährleisten. Mögliche Variationen sind eine starre Ankopplung an die Oberseite des thermoelektrischen Generators 104 oder die Leiterplatte 102 und der Einsatz von zusätzlichen Metallspacern unterhalb des thermoelektrischen Generators 104.

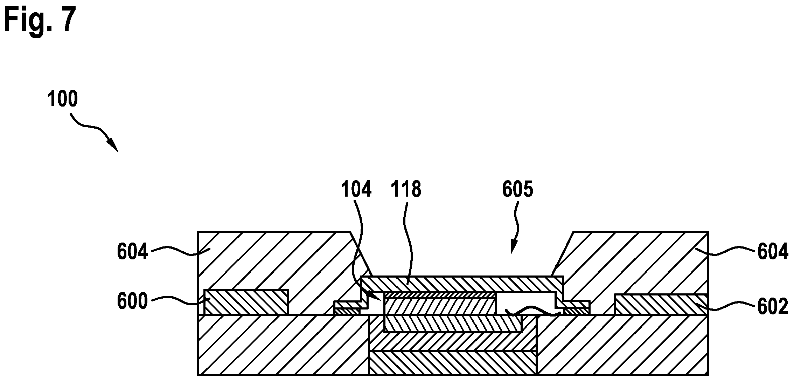

Fig. 7 zeigt wiederum in einer Schnittdarstellung ein weiteres Ausführungsbeispiel der thermoelektrischen Vorrichtung 100 mit weiteren Modulen 600, 602. Im Unterschied zu dem in Fig. 6 gezeigten Ausführungsbeispiel der Ausführung als Sensorknoten 100 mit dem thermoelektrischen Generator 104 ist bei dem in Fig. 7 gezeigten Aufbau die Bestückung des thermoelektrischen Generators 104 und des (hier nicht dargestellten) Kühlkörpers vor dem Molden durchgeführt worden. Die frei gehaltene Fläche 605 wurde dadurch verkleinert, und die Moldmasse 604 dient zusätzlich als Befestigung des metallischen Kühlkörpers oder zur Befestigung des Deckels. Das Gehäuse wird auch hier durch den Metalldeckel 118 mit mechanischer Entkopplung realisiert. Der Deckel 118 wird mit einem speziellen Moldwerkzeug während des Moldprozesses frei gestellt. Mögliche Variationen sind die gleichen wie in Fig. 6 aufgeführt.

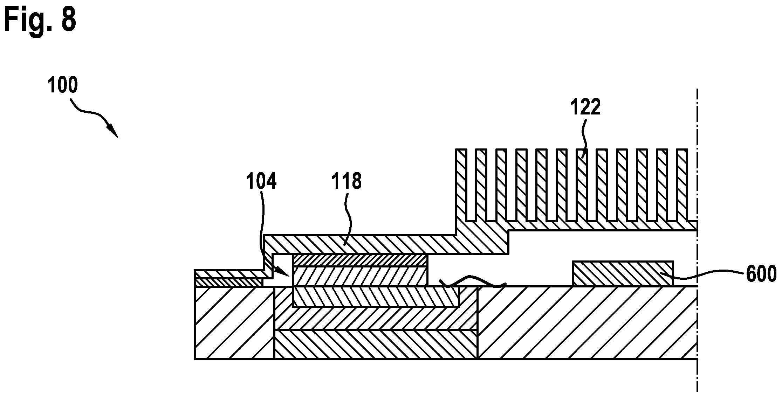

Fig. 8 zeigt in einer Schnittdarstellung die thermoelektrische Vorrichtung 100 in einer weiteren Ausführung. In der Darstellung ist ein Abschnitt der thermoelektrischen Vorrichtung 100 links von einer mit einer Strich-Punkt-Linie gekennzeichneten Schnitt- bzw. Symmetrielinie gezeigt. Die Besonderheit bei dieser Variante ist der Einsatz des Kühlkörpers 122 als Deckel ohne Verwendung zusätzlicher Moldmasse. Das Gehäuse wird hier also durch den Kühlkörper 122 realisiert, indem dieser gleichzeitig einen Metalldeckel darstellt. Der thermoelektrische Generator 104 ist in dem Gehäuse 122 aus der Mitte an die Seite der Leiterplatte 102 verschoben. Dies bietet die Möglichkeit, mehr als einen thermoelektrischen Generator 104 oder - wie hier- ein elektronisches Bauelement 600 in den Sensorknoten 100 einzusetzen und den thermoelektrischen Generator 104 und das weitere Modul 600 thermisch voneinander zu trennen, wobei gleichzeitig, wie in Fig. 8 gezeigt, der Kühlkörper 122 als Deckel das thermoelektrische Bauelement 104 und das weitere Modul bzw. Bauteil 600 überdeckt. Der thermoelektrische Generator 104 ist mechanisch entkoppelt durch den Metalldeckel 122 kontaktiert.

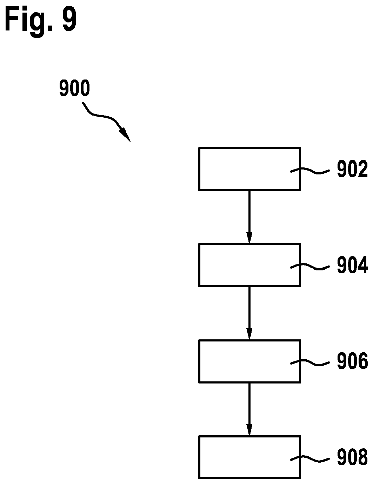

Fig. 9 zeigt ein Ablaufdiagramm eines Ausführungsbeispiels eines Verfahrens 900 zum Herstellen einer thermoelektrischen Vorrichtung. In einem Schritt 902 wird ein thermoelektrisches Bauelement bereitgestellt, das sich aus einer ersten Platte, einer zweiten Platte und einem Zwischenbereich mit einer Mehrzahl von sich zwischen der ersten Platte und der zweiten Platte erstreckenden thermoelektrischen Elementen zusammensetzt. In einem Schritt 904 wird ein Träger, dessen Oberfläche eine Vertiefung aufweist, bereitgestellt. In einem Schritt 906 wird ein elastisches Material in die Vertiefung des Trägers eingefüllt, um diese ganz oder teilweise zu füllen. In einem Schritt 908 wird das thermoelektrische Bauelement in das elastische Material in der Vertiefung eingesetzt und so mit dem Träger stressentkoppelnd verbunden.

Die hierin vorgestellte Erfindung kann am Erzeugnis bereits durch optische Inspektion sehr einfach nachgewiesen werden.

Das hier vorgestellte Konzept der mechanisch entkoppelten Anbindung eines thermoelektrischen Bauelements an ein Sensormodul wird in naher Zukunft notwendig für (teil-)autonome Sensoren aus dem Bereich "Internet der Dinge" mit Fokus auf einer effizienten Energieversorgung aus der Umgebung.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Thermoelektrische Vorrichtung (100) mit folgenden Merkmalen:
einem Träger (102), wobei eine Oberfläche (108) des Trägers (102) eine Vertiefung (106) aufweist;
einem elastischen Material (110), mit dem zumindest ein Boden (112) der Vertiefung (106) ausgekleidet ist; und
einem thermoelektrischen Generator (104), der in der Vertiefung (106) angeordnet ist, wobei der thermoelektrische Generator (104) über das elastische Material (110) mit dem Träger (102) verbunden ist, und wobei der thermoelektrische Generator (104) eine dem Boden (112) der Vertiefung (106) zugewandte erste Platte (124), eine von dem Boden (112) der Vertiefung (106) abgewandte zweite Platte (126) und einen Zwischenbereich (128) mit einer Mehrzahl von sich zwischen der ersten Platte (124) und der zweiten Platte (126) erstreckenden thermoelektrischen Elementen (302) aufweist.

2. Thermoelektrische Vorrichtung (100) gemäß Anspruch 1, bei der der Zwischenbereich (128) des thermoelektrischen Generators (104) innerhalb der Vertiefung (106) angeordnet ist.

3. Thermoelektrische Vorrichtung (100) gemäß einem der vorangegangenen Ansprüche, bei der der Boden (112) der Vertiefung (106) als ein metallischer Einsatz in den Träger (102) ausgebildet ist.

4. Thermoelektrische Vorrichtung (100) gemäß einem der vorangegangenen Ansprüche, bei der der Boden (112) der Vertiefung (106) einstückig mit dem Träger (102) gebildet ist und zumindest eine metallische Durchkontaktierung aufweist.

5. Thermoelektrische Vorrichtung (100) gemäß einem der vorangegangenen Ansprüche, bei der das elastische Material (110) ein thermisch isolierendes Material ist.

6. Thermoelektrische Vorrichtung (100) gemäß einem der Ansprüche 1 bis 4, bei der das elastische Material (110) ein thermisch leitendes Material ist.

7. Thermoelektrische Vorrichtung (100) gemäß einem der vorangegangenen Ansprüche, bei der das elastische Material (110) in einem Bereich zwischen dem Boden (112) der Vertiefung (106) und der ersten Platte (124) des thermoelektrischen Generators (104) einen Füllstoff (300) zur Erhöhung einer thermischen Leitfähigkeit zwischen dem Träger (102) und der ersten Platte (124) des thermoelektrischen Generators (104) aufweist.

8. Thermoelektrische Vorrichtung (100) gemäß einem der vorangegangenen Ansprüche, die ein weiteres elastisches Material (400) aufweist, das zwischen der Wandung (114) der Vertiefung (106) und dem thermoelektrischen Generators (104) angeordnet ist, wobei das weitere elastische Material (400) thermisch isolierend ist.

9. Thermoelektrische Vorrichtung (100) gemäß einem der vorangegangenen Ansprüche, wobei die thermoelektrische Vorrichtung (100) einen Deckel (118) zur zumindest teilweisen Abdeckung des thermoelektrischen Generators (104) aufweist, wobei ein Randbereich des Deckels (118) mittels eines Haftmittels (120) an der Oberfläche (108) des Trägers (102) befestigt ist.

10. Thermoelektrische Vorrichtung (100) gemäß Anspruch 9, bei der der Deckel (118) ausgebildet ist, um zumindest ein weiteres elektronisches Bauelement (600, 602) der thermoelektrischen Vorrichtung (100) abzudecken.

11. Verfahren (900) zum Herstellen einer thermoelektrischen Vorrichtung (100) mit folgenden Schritten:
Bereitstellen (902) eines thermoelektrischen Generators (104), der eine erste Platte (124), eine zweite Platte (126) und einen Zwischenbereich (128) mit einer Mehrzahl von sich zwischen der ersten Platte (124) und der zweiten Platte (126) erstreckenden thermoelektrischen Elementen (302) aufweist;
Bereitstellen (904) eines Trägers (102), wobei eine Oberfläche (108) des Trägers (102) eine Vertiefung (106) aufweist;
Einbringen (906) eines elastischen Materials (110) in die Vertiefung (106) des Trägers (102), um den Freiraum zumindest teilweise zu füllen; und
Einsetzen (908) des thermoelektrischen Generators (104) in die Vertiefung (106), um den thermoelektrischen Generator (104) über das elastische Material (110) mit dem Träger (102) zu verbinden.

## Claims

1. Thermoelectric device (100) with the following features:
a carrier (102), wherein a surface (108) of the carrier (102) has a recess (106);
an elastic material (110), with which at least a bottom (112) of the recess (106) is lined; and
a thermoelectric generator (104), which is arranged in the recess (106), wherein the thermoelectric generator (104) is connected to the carrier (102) via the elastic material (110), and wherein the thermoelectric generator (104) has a first plate (124) facing towards the bottom (112) of the recess (106), a second plate (126) facing away from the bottom (112) of the recess (106), and an intermediate region (128) having a plurality of thermoelectric elements (302) extending between the first plate (124) and the second plate (126).

2. Thermoelectric device (100) according to Claim 1, in which the intermediate region (128) of the thermoelectric generator (104) is arranged inside the recess (106).

3. Thermoelectric device (100) according to either of the preceding claims, in which the bottom (112) of the recess (106) is in the form of a metallic insert into the carrier (102).

4. Thermoelectric device (100) according to one of the preceding claims, in which the bottom (112) of the recess (106) is formed in one piece with the carrier (102) and has at least one metallic plated-through hole.

5. Thermoelectric device (100) according to one of the preceding claims, in which the elastic material (110) is a thermally insulating material.

6. Thermoelectric device (100) according to one of Claims 1 to 4, in which the elastic material (110) is a thermally conducting material.

7. Thermoelectric device (100) according to one of the preceding claims, in which, in a region between the bottom (112) of the recess (106) and the first plate (124) of the thermoelectric generator (104), the elastic material (110) comprises a filler (300) for increasing a thermal conductivity between the carrier (102) and the first plate (124) of the thermoelectric generator (104).

8. Thermoelectric device (100) according to one of the preceding claims, said thermoelectric device having a further elastic material (400), which is arranged between the wall (114) of the recess (106) and the thermoelectric generator (104), wherein the further elastic material (400) is thermally insulating.

9. Thermoelectric device (100) according to one of the preceding claims, wherein the thermoelectric device (100) has a cover (118) for at least partially covering the thermoelectric generator (104), wherein a marginal region of the cover (118) is fastened by means of an adhesive (120) to the surface (108) of the carrier (102).

10. Thermoelectric device (100) according to Claim 9, in which the cover (118) is embodied to cover at least one further electronic component (600, 602) of the thermoelectric device (100).

11. Method (900) for producing a thermoelectric device (100), said method comprising the following steps:
providing (902) a thermoelectric generator (104), which has a first plate (124), a second plate (126), and an intermediate region (128) having a plurality of thermoelectric elements (302) extending between the first plate (124) and the second plate (126);
providing (904) a carrier (102), wherein a surface (108) of the carrier (102) has a recess (106);
introducing (906) an elastic material (110) into the recess (106) of the carrier (102), in order to at least partially fill the clearance; and
inserting (908) the thermoelectric generator (104) into the recess (106), in order to connect the thermoelectric generator (104) to the carrier (102) via the elastic material (110).

## Revendications

1. Dispositif thermoélectrique (100), présentant les caractéristiques suivantes:
un support (102), dans lequel une surface (108) du support (102) présente un creux (106);
un matériau élastique (110), dont au moins un fond (112) du creux (106) est revêtu; et
un générateur thermoélectrique (104), qui est disposé dans le creux (106), dans lequel le générateur thermoélectrique (104) est assemblé au support (102) par l'intermédiaire du matériau élastique (110), et dans lequel le générateur thermoélectrique (104) présente une première plaque (124) tournée vers le fond (112) du creux (106), une seconde plaque (126) détournée du fond (112) du creux (106) et une région intermédiaire (128) munie d'une multiplicité d'éléments thermoélectriques (302) s'étendant entre la première plaque (124) et la seconde plaque (126).

2. Dispositif thermoélectrique (100) selon la revendication 1, dans lequel la région intermédiaire (128) du générateur thermoélectrique (104) est disposée à l'intérieur du creux (106).

3. Dispositif thermoélectrique (100) selon l'une quelconque des revendications précédentes, dans lequel le fond (112) du creux (106) est réalisé sous la forme d'un insert métallique dans le support (102).

4. Dispositif thermoélectrique (100) selon l'une quelconque des revendications précédentes, dans lequel le fond (112) du creux (106) est formé d'une seule pièce avec le support (102) et présente au moins un contact traversant métallique.

5. Dispositif thermoélectrique (100) selon l'une quelconque des revendications précédentes, dans lequel le matériau élastique (110) est un matériau thermiquement isolant.

6. Dispositif thermoélectrique (100) selon l'une quelconque des revendications 1 à 4, dans lequel le matériau élastique (110) est un matériau thermiquement conducteur.

7. Dispositif thermoélectrique (100) selon l'une quelconque des revendications précédentes, dans lequel le matériau élastique (110) présente dans une région située entre le fond (112) du creux (106) et la première plaque (124) du générateur thermoélectrique (104) une matière de remplissage (300) pour augmenter une conductibilité thermique entre le support (102) et la première plaque (124) du générateur thermoélectrique (104) .

8. Dispositif thermoélectrique (100) selon l'une quelconque des revendications précédentes, qui présente un autre matériau élastique (400), qui est disposé entre la paroi (114) du creux (106) et le générateur thermoélectrique (104), dans lequel l'autre matériau élastique (400) est thermiquement isolant.

9. Dispositif thermoélectrique (100) selon l'une quelconque des revendications précédentes, dans lequel le dispositif thermoélectrique (100) présente un couvercle (118) pour le recouvrement au moins partiel du générateur thermoélectrique (104), dans lequel une région de bord du couvercle (118) est fixée au moyen d'un agent adhésif (120) à la surface (108) du support (102).

10. Dispositif thermoélectrique (100) selon la revendication 9, dans lequel le couvercle (118) est réalisé de façon à recouvrir au moins un autre composant électronique (600, 602) du dispositif thermoélectrique (100).

11. Procédé (900) de fabrication d'un dispositif thermoélectrique (100), comprenant les étapes suivantes:
préparer (902) un générateur thermoélectrique (104), qui présente une première plaque (124), une seconde plaque (126) et une région intermédiaire (128) munie d'une multiplicité d'éléments thermoélectriques (302) s'étendant entre la première plaque (124) et la seconde plaque (126);
préparer (904) un support (102), dans lequel une surface (108) du support (102) présente un creux (106);
introduire (906) un matériau élastique (110) dans le creux (106) du support (102), afin de remplir au moins en partie l'espace libre; et
insérer (908) le générateur thermoélectrique (104) dans le creux (106), afin d'assembler le générateur thermoélectrique (104) au support (102) par l'intermédiaire du matériau élastique (110).
